# EUROPEAN PATENT APPLICATION

(11) **EP 4 632 814 A2**
(43) Date of publication of application: **15.10.2025**
(21) Application number: 25164030.6
(22) Date of filing: 17.03.2025
(51) Int. Cl.: H01L 25/065, H01L 25/18

(54) **SYSTEM AND METHODS FOR BRIDGE ARCH FOR SEMICONDUCTOR PACKAGES**

(30) Priority: 21.03.2024 US 202463568401 P; 05.06.2024 US 202463656597 P; 03.10.2024 US 202418906164
(71) Applicant: Samsung Electronics Co., Ltd., Suwon-si, Gyeonggi-do 16677 (KR)
(72) Inventor: YANG, Jin, San Jose, CA, 95134 (US)
(74) Representative: Kuhnen & Wacker Patent- und Rechtsanwaltsbüro PartG mbB

(57) **Abstract**

Disclosed herein are methods, systems and devices including a first layer with a first compute device, a first device package, and a second device package, with the first compute device between the first device package and the second device package. The device may include a second layer with a first connecting element and a second connecting element, the first connecting element electrically connecting the first compute device to the first device package, and the second connecting element electrically connecting the first compute device to the second device package.

## Description

### TECHNICAL FIELD

The subject matter disclosed herein relates to microelectronics packaging and integrated circuits (IC) packaging. More particularly, the subject matter disclosed herein relates to a package architecture featuring bridge arches.

### BACKGROUND

Semiconductor devices may connect to additional devices and circuitry on different substrates. Forming connections between substrates can provide increased computation. However, forming connections between substrates can cause complications. Packaging describes the general method for connecting and integrating multiple computational components together in an integrated unit, and may involve multiple different types of integrated circuits on multiple substrates which may combine into a single unit. Packaging may also describe the method for which multiple computational components within a single unit are protected by the use of various techniques to provide thermal, physical and electrical protection. Background concepts discussed herein are for informational purposes only and are not intended to limit the present disclosure. Nor should the background or field described herein be intended to limit the disclosure herein to a particular use or concept.

### SUMMARY

An example embodiment provides a device including a first layer with a first compute device, a first device package, and a second device package, with the first compute device between the first device package and the second device package. The device may include a second layer with a first connecting element and a second connecting element, the first connecting element electrically connecting the first compute device to the first device package, and the second connecting element electrically connecting the first compute device to the second device package. In some embodiments, the first layer may include a third device package and a fourth device package, with the first compute device between the third device package and the fourth device package. A third connecting element may electrically connect the first compute device to the third package device, and a fourth connecting element may electrically connect the first compute device to the fourth package device. The first compute device may be between the second device package and the fourth device package. In some embodiments, the first connecting element may include a first interface logic, which may include a serial interface logic or a parallel interface logic. In some embodiments, the first connecting element may include a first interface logic which may connect the first compute device to the first device package. In some embodiments, the second layer may include a first redistribution layer on a first side of the second layer, the first side of the second layer facing the first layer, and a second redistribution layer on a second side of the second layer, the second side of the second layer opposite the first side of the second layer. In some embodiments, the first connecting element may be between the first redistribution layer and the second redistribution layer. In some embodiments, the first device package may include at least a first device stack and a second device stack on a first device die. In some embodiments, the first device stack may include at least one of a memory device and a processing device. In some embodiments, the first device die may couple the first device stack and the second device stack to the first connecting element.

An example embodiment provides a system including a first layer with a first compute device, a first device package, a second device package, and the first compute device is between the first device package and the second device package. A second layer may include a first connecting element and a second connecting element, the first connecting element electrically coupling the first compute device to the first device package, and the second connecting element electrically coupling the first compute device to the second device package. The first connecting element may include a first interface logic and the second connecting element may include a second interface logic. In some embodiments, the first layer may include a second compute device, a third device package, and a fourth device package. The second compute device may between the fourth device package and the third device package. The second layer may, in some embodiments, include a third connecting element and a fourth connecting element, the third connecting element electrically coupling the second compute device to the third device package, and the fourth connecting element electrically coupling the second compute device to the fourth device package. The third connecting element may include a third interface logic and the fourth connecting element may include a fourth interface logic. In some embodiments, the second layer may include a first redistribution layer on a first side of the second layer, the first redistribution layer between the first connecting element and the first device package. In some embodiments, the second layer may include a second redistribution layer on a second side of the second layer, the first connecting element between the first redistribution layer and the second redistribution layer. In some embodiments the first device may include one or more of a memory device and a processing device. In some embodiments, the first layer may include a base die between the first compute device and the first connecting element.

An example embodiment provides a method, the method including forming an interposer with a first redistribution layer on a first side of the interposer; forming a first connecting element and a second connecting element on the first redistribution layer; forming a second redistribution layer on a second side of the interposer, the second side of the interposer opposite the first side, the second redistribution layer communicatively coupling the first connecting element and the second connecting element; mounting a compute device on the interposer and the second redistribution layer; mounting a first device package and a second device package on the interposer and on the second redistribution layer, the compute device between the first device package and the second device; depositing a dielectric layer over the interposer; coupling the first device package to the compute device via the first connecting element; and coupling the second device package to the compute device via the second connecting element. In some embodiments, the first device package and the second device package have substantially the same device composition. In some embodiments, mounting the compute device on the interposer may include mounting a base die on the second redistribution layer and mounting the compute device on the base die. In some embodiments, forming the first connecting layer on the first redistribution layer may include forming a first microball array on the first redistribution layer and mounting the first connecting element on the first microball array. In some embodiments, depositing the dielectric layer over the interposer may include depositing dielectric material between the first device package, the second device package, and the compute device.

### BRIEF DESCRIPTION OF THE DRAWING

In the following section, the aspects of the subject matter disclosed herein will be described with reference to exemplary embodiments illustrated in the figures, in which:
FIG. 1A depicts a perspective view of an example embodiment of a packaging structure according to various embodiments of the subject matter disclosed herein;
FIG. 1B depicts an enlarged perspective view of an example embodiment of a packaging structure according to various embodiments of the subject matter disclosed herein;
FIG. 2 depicts a plan view of an example embodiment of a packaging structure according to various embodiments of the subject matter disclosed herein;
FIG. 3 depicts a cross-section view of an example embodiment of a packaging structure according to various embodiments of the subject matter disclosed herein;
FIG. 4A depicts a cross-section view of an example embodiment of a packaging structure assembly at a first time according to various embodiments of the subject matter disclosed herein;
FIG. 4B depicts a cross-section view of an example embodiment of a packaging structure assembly at a second time according to various embodiments of the subject matter disclosed herein;
FIG. 4C depicts a cross-section view of an example embodiment of a packaging structure assembly at a third time according to various embodiments of the subject matter disclosed herein;
FIG. 4D depicts a cross-section view of an example embodiment of a packaging structure assembly at a fourth time according to various embodiments of the subject matter disclosed herein;
FIG. 4E depicts a cross-section view of an example embodiment of a packaging structure assembly at a fifth time according to various embodiments of the subject matter disclosed herein;
FIG. 4F depicts a cross-section view of an example embodiment of a packaging structure assembly at a sixth time according to various embodiments of the subject matter disclosed herein;
FIG. 4G depicts a cross-section view of an example embodiment of a packaging structure assembly at a seventh time according to various embodiments of the subject matter disclosed herein; and
FIG. 5 depicts an example embodiment of a method of forming a package structure according to various embodiments of the subject matter disclosed herein;
FIG. 6 depicts a cross-section view of an example embodiment of a packaging structure assembly according to various embodiments of the subject matter disclosed herein; and
FIG. 7 depicts a plan view of an example embodiment of a packaging structure assembly according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, the substrates may contain circuits such as integrated circuits including central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), graphical processing units (GPUs), other forms of auxiliary processing units (xPU), artificial intelligence (AI) chips, high bandwidth memory (HBM) interfaces, and other application-specific integrated circuits (ASIC). In some embodiments, a combination of circuits may be present on a substrate. In some embodiments, a substrate may include a packaged chip.

As used herein, high bandwidth memory or HBM, may refer to a chip structure including one or more HBM modules. In some embodiments, the HBM may be manufactured by an advance silicon node process.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be electrically connected using a via traveling through an interposer such as another substrate or chip. In some embodiments, an interconnection may be formed using connections on a surface of a substrate, such as a pad, and may use additional materials between the pads such as solder to form an interconnection.

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, hybrid bonding may be defined as bonding both conductive portions to conductive portions, such as a metal-metal bond, and bonding dielectric portions to dielectric portions such as a dielectric-dielectric bond.

As used herein, a connecting element refers to a substrate, die, or other material having one or more conductive pathways able to form connection between one or more semiconductor devices, as well as substrates, interposers, or other package structures. A connecting element may include one or more traces, the traces forming a connection pathway along the connecting element between one or more devices coupled to the connecting element. An embedded connecting element, as used herein, may refer to a connecting element in a layer within a semiconductor package, and may be used interchangeably with connecting element. An active connecting element may refer to a connecting element featuring additional features beyond connections, such as transistors, vias, and other circuit components. As used herein, a connecting element may be referred to as a connector, a bridge, or a bridge arch; an active connecting element may be referred to as an active bridge, an active bridge arch, or an active connector; and an embedded connecting element may be referred to as an embedded bridge, an embedded bridge arch, or an embedded connector.

Disclosed herein are various embodiments of devices, systems and methods related to packaging architecture to modularly create a stack logic and memory building block architecture. Increasing the number of devices and number of device stacks may utilize additional methods of connecting compute devices to device stacks to allow denser computation. A stack logic and memory building block architecture may include a base chip providing logic, routing, and power delivery to one or more device stacks. A multiple-stack die may include one or more device stacks on a shared substrate. The multiple-stack die may then be mounted on a shared interposer with a compute device and additional multiple-stack dies. Signals between the compute devices and the device stacks may be routed via the shared interposer, including via one or more connecting elements which may be embedded in the shared interposer between two or more redistribution layers. As used herein, a device stack or stack of devices may refer to a combination of memory and supporting circuit architecture, for example, chiplets and dies containing individual memory elements, supporting processing units, I/O circuitry, and other forms of integrated chips.

As disclosed herein, in some embodiments, the connecting elements between devices may be active connecting elements, with the connecting element including one or more additional circuit elements such as transistors, vias, and other circuit components, such as capacitors, resistors, or any other suitable circuit elements. In some embodiments, an active connecting element may include a logic unit to provide a routing interface between one or more device stacks.

In some embodiments, a back-side power delivery network (BSPDN) may be formed on the back side of a substrate, with a signal network formed on the front side of the same substrate. In some embodiments, the BSPDN and signal network may be formed on separate substrates and transferred to the same substrate. The BSPDN and signal network may be separated by a transistor layer. The transistor layer may include a plurality of transistors. The transistors may provide different functions and take different forms, including a logic layer. The BSPDN and signal network may form a single monolithic structure on the same die in a semiconductor foundry process. A stacked device module may separately be formed in a semiconductor foundry process, the same semiconductor foundry process, or may have multiple components formed in multiple semiconductor foundry processes and assembled in a packaging assembly process. In some embodiments, an embedded connecting element may between the BSPDN and the signal network layer. In some embodiments, the transistor layer may be formed as part of an active connecting element. In some embodiments, a via between layers may be formed within an active connecting element.

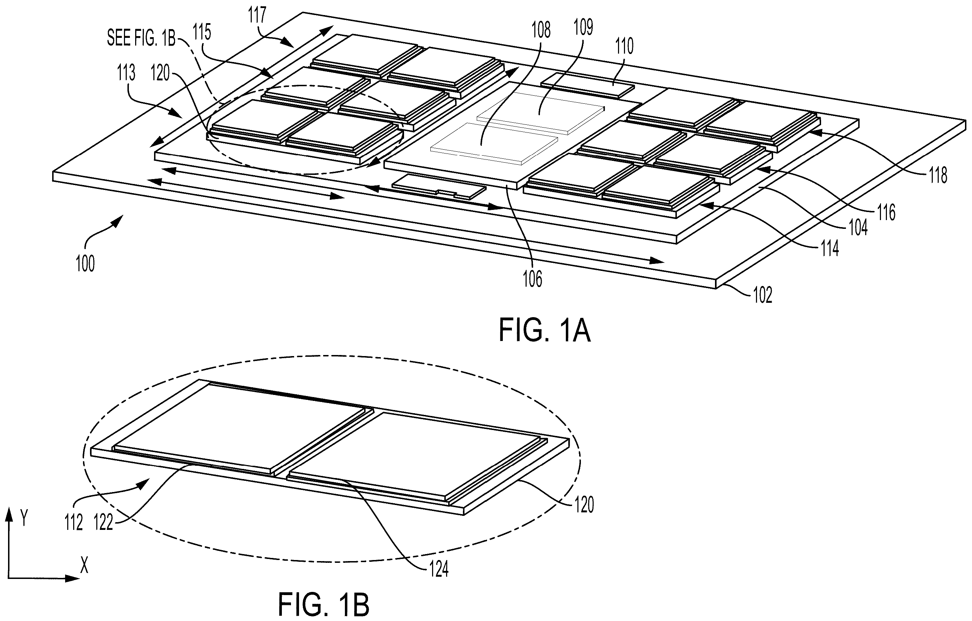

FIG. 1A depicts a perspective view of an exemplary embodiment of a device package architecture 100. FIG. 1B provides an expanded view of a portion of the device package architecture 100. A supporting substrate 102 supports an interposer 104. The interposer 104 connects one or more multi-device packages 112 on a multi-device die 120 to a first compute device 108 and a second compute device 109. The first compute device 108 and the second compute device 109 may be mounted on a base die 106. In some embodiments, a single compute device may be used, while in other embodiments, additional compute devices may be added, for example 4, 6, 8, 16 or 32 compute devices may be added. In some embodiments, the first compute device 108 and the second compute device 109 may share the same base die 106, while in other embodiments, each compute device may have a separate base die 106. In some embodiments, the base die 106 may be a silicon die, while in other embodiments a variety of semiconductor materials may be used. In some embodiments, the compute devices may include a die, a core, or chiplet, as well as any other suitable form of circuit. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit.

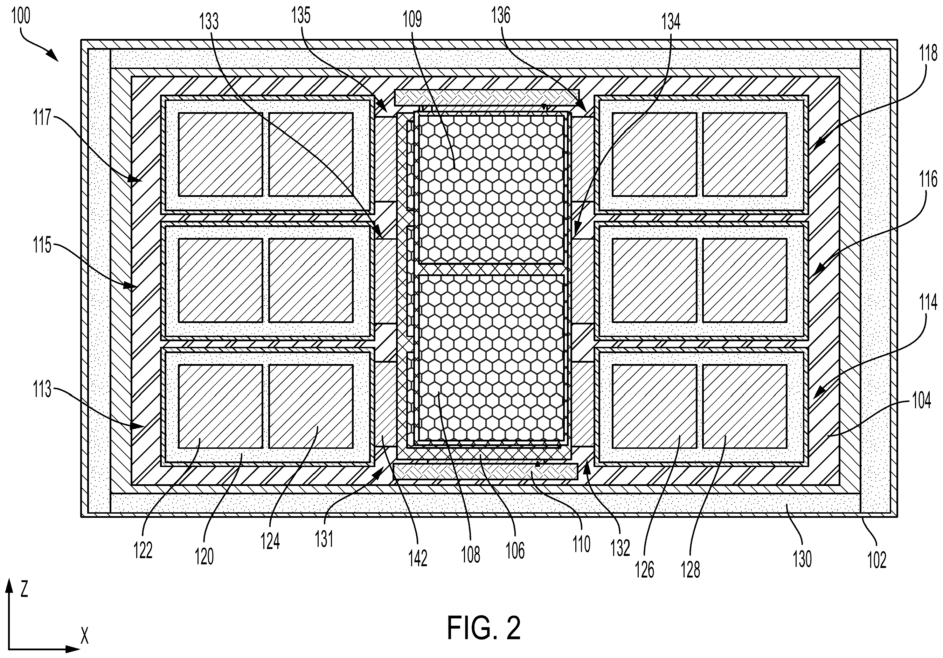

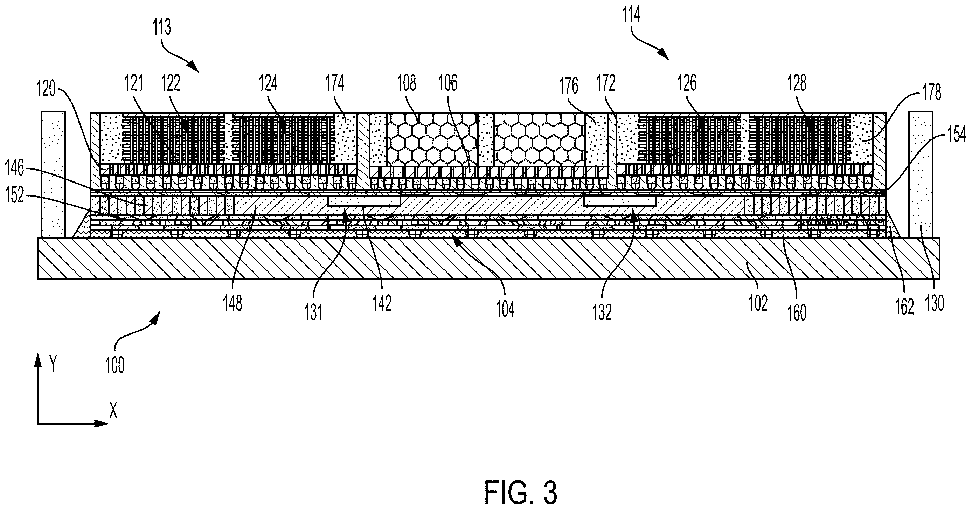

FIG. 2 provides a plan view of the device package architecture 100 showing the layout of the first compute device 108 and the second compute device 109 on the interposer 104. FIG. 3 provides a cross-sectional view of the device package architecture 100, showing the one or more multi-device packages 112 mounted on the interposer 104. The one or more multi-device packages 112 may include be a plurality of multi-device packages. In the example embodiment shown in FIGS. 1 and 2, included are a first multi-device package 113, a second multi-device package 114, a third multi-device package 115, a fourth multi-device package 116, a fifth multi-device package 117, and a sixth multi-device package 118. The first multi-device package 113, the third multi-device package 115 and the fifth multi-device package 117 are on a first side of the base die 106, while the second multi-device package 114, the fourth multi-device package 116 and the sixth multi-device package 118 are on a second side of the base die 106, opposite the first side.

The one or more multi-device packages 112 may each include a multi-device die 120 upon which are mounted multiple devices in the form of chips or dies. In some embodiments, the multi-device die 120 may have mounted upon it a first device 122 and a second device 124. In some embodiments, the devices may be various forms of memory including DRAM, SRAM, and other forms of memory. In some embodiments, the devices may include a core device, for example a processor, processing device, or other form of microcontroller to act as a controller. In some embodiments, the first device 122 and the second device 124 may each comprise a stack of one or more component devices. In some embodiments, the stack of component devices may include memory devices, core devices, and combinations thereof. The first device 122 and the second device 124 may, in some embodiments, include the same component devices, while in other embodiments the component devices in the first device 122 and the second device 124 may differ. In some embodiments, a through-via may electrically connect the individual devices within a device stack to each other and to the multi-device die 120.

The number of component devices within each stack of devices may vary, and the number of devices and type of component devices provided may vary based on the relative amount of computing desired for each device. For example, a desired ratio between core dies and memory dies may be desired, for example 1 core per 4 memory dies may be desired in some embodiments. However, in other embodiments, the ratio may vary, for example, and in some embodiments the ratio may be greater and include 1 core per 5, 6, 10, or even 16 memory die.

Additionally, as seen in the exemplary view of FIG. 3, a first encapsulation layer 174 may be provided between the first device 122, the second device 124 and multi-device die 120. The first encapsulation layer 174 may be provided as a dielectric layer or an adhesive layer such as a resin or epoxy. In some embodiments, dielectric material such as silicon nitride (Si₃N₄), silicon dioxide (SiO₂), or any other suitable dielectric material, may be used to form the first encapsulation layer 174. In some embodiments, the first device 122 and the second device 124 may be encapsulated by the first encapsulation layer 174, and may include additional encapsulations layers upon the sides or top of the first device 122 and the second device 124.

In some embodiments, one or more central encapsulation layers 176 may surround the compute devices including the first compute device 108 and the second compute device 109. In the example embodiment of FIG. 3, the central encapsulation layer(s) 176 may surround the first compute device 108 and the second compute device 109. Additionally, one or more overmolding layers 172 may surround the compute devices and the one or more multi-device packages 112. The overmolding layers 172 may be a dielectric material, and in some embodiments, the molding layer may provide mechanical support, such as holding the devices in places, as well as may provide electrical isolation, and may provide a thermal path for heat from the devices to transfer via.

On the one or more multi-device packages 112, the first device 122 and the second device 124 may be electrically coupled to one or more wiring layers 121 within the multi-device die 120. The one or more wiring layers 121 within the multi-device die 120 may, in turn, couple the first device 122 and the second device 124 to the interposer 104. The interposer 104 may include one or more redistribution layers allowing the first device 122 and the second device 124 to electrically couple to the first compute device 108 and/or the second compute device 109 via the base die 106. The base die 106 may further include a base redistribution layer allowing the first compute device 108 and the second compute device 109 to communicate with the supporting substrate 102.

While in the exemplary embodiment of FIG. 1A to 3, the first device 122 and the second device 124 are shown upon a single one of the one or more multi-device packages 112, each of the one or more multi-device packages 112 may include a pair of devices upon their respective multi-device die 120. Within the context of the exemplary embodiment shown in FIG. 3, the first multi-device package 113 includes the first device 122 and the second device 124, while a third device 126 and a fourth device 128 are shown on the second multi-device package 114. The third device 126 and the fourth device 128 may include a second encapsulation layer 178, similar to the first encapsulation layer 174.

Although referred to as wiring layers, the one or more wiring layers 121 may take the form of series of pads, bumps, vias, through-vias, traces, redistribution layers and other forms of connection for redistributing signals in various combinations. Similarly, the one or more redistribution layers and the base redistribution layer may also take the form of series of pads, bumps, vias, through-vias, traces, redistribution layers and other forms of connection for redistributing signals in various combinations.

In some embodiments, the supporting substrate 102 may be an organic substrate such as a polymer, while in other embodiments an inorganic substrate such as a semiconductor including silicon may be used, or alternatively a SOI substrate such as glass. In some embodiments, the interposer 104 may be made of silicon, while in other embodiments another form of semiconductor such as germanium may be used. In some embodiments, multiple interposer substrates may be shared on a single supporting substrate. In some embodiments, the supporting substrate 102 may be multiple substrates, and in some embodiments may be multiple substrates stacked upon each other. The supporting substrate 102 may have the interposer 104 mounted thereon in a variety of ways and may include pads, bumps, microbumps, pillars, balls, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The mounting method may further include a dielectric material, which may include a material such as an adhesive, resin, or elastomer which may form a connection in addition to a conductive connection. In some embodiments, the combination of a conductive connection and a dielectric connection may form a hybrid bond.

The interposer 104 may contain additional devices in addition to or in alternative to the compute devices and the multi-device packages. In the exemplary embodiment of FIG. 1A, one or more of a connectivity chiplet 110 may be mounted upon the interposer 104. The connectivity chiplet 110 may contain I/O circuitry to allow the device package architecture 100 to connect to additional devices. For example, in some embodiments, the connectivity chiplet 110 may provide wireless connections, using one or more form of radiofrequency protocol for one or more frequency spectrums. In some embodiments, the connectivity chiplet 110 may provide for optical communication or wired communications, alone or in some combination with wireless communications.

Additionally, as shown in the exemplary embodiment of FIG. 2 and FIG. 3, a stiffener 130 may surround the perimeter of the supporting substrate 102. The stiffener 130 may be one or more sections of a stiff material to provide additional mechanical support to the supporting substrate 102. The stiffener 130 may be made of a material that has a higher elastic modulus than the elastic modulus of the supporting substrate 102, and thus may include materials such as a metal (e.g., aluminum, copper, or steel), a ceramic, a composite material, or another appropriate material. The stiffener 130 may be used in combination with a lid design to provide additional protection for the device package architecture 100, including protection from mechanical distortions, deformations, and warping. In some embodiments, a lid may be used to provide additional mechanical, thermal, and electrical protection for the device package architecture 100. In some embodiments, a lidless design may be used instead.

Also shown in FIG. 3 is a bonding layer 160. The bonding layer 160 may include conductive interconnections to electrically couple the interposer 104 to the supporting substrate 102. Such conductive interconnections may include pads, bumps, microbumps, pillars, balls, and other forms such as C4 bumps, alone or in combination. In some embodiments, the bonding layer 160 may also include a dielectric material or an adhesive to provide additional strength and connection between the interposer 104 and the supporting substrate 102. In some embodiments, the bonding layer 160 may provide a metallic bonding between the interposer 104 and the supporting substrate 102, a dielectric bonding between the interposer 104 and the supporting substrate 102, or in some embodiments a hybrid bonding between the interposer 104 and the supporting substrate 102. In some embodiments, a dielectric material or adhesive material may be inserted using an underfill technique and form a dielectric bond 162 on the surface of the supporting substrate 102.

The interposer 104 may include one or more embedded connecting elements 142 to provide a connection between the base die 106 and the one or more multi-device packages 112. The one or more embedded connecting elements 142 may include one or more conductive pathways to provide an electrical coupling between the base die 106 and the one or more multi-device packages 112. In some embodiments, the one or more embedded connecting elements 142 may be used to electrically connect the base die 106 to a plurality of the one or more multi-device packages 112, while in other embodiments the one or more embedded connecting elements 142 may electrically connect the base die 106 to only one of the multi-device packages 112. In some embodiments, a plurality of the embedded connecting elements 142 may be used to electrically connect each of the multi-device packages 112 to the base die 106, with one or more of the embedded connecting element 142 for each of the multi-device packages 112.

The one or more embedded connecting elements 142 may include a first embedded connecting element 131 to connect the base die 106 to the first multi-device package 113, a second embedded connecting element 132 to connect the base die 106 to the second multi-device package 114, a third embedded connecting element 133 to connect the base die 106 to the third multi-device package 115, a fourth embedded connecting element 134 to connect the base die 106 to the fourth multi-device package 116, a fifth embedded connecting element 135 to connect the base die 106 to the fifth multi-device package 117, and a sixth embedded connecting element 136 to connect the base die 106 to the sixth multi-device package 118.

In addition, the interposer 104 may include a first redistribution layer (RDL) 152 on the bottom side of the interposer 104 and a second RDL 154 on the top side of the interposer 104. Furthermore, conductive pillars 146 may electrically connect the first RDL 152 to the second RDL 154. The interposer 104 may include a molding layer 148 between the first RDL 152 and the second RDL 154. In some embodiments, the molding layer 148 may be a dielectric material providing thermal insulation, mechanical separation, and electrical insulation between the first RDL 152, the second RDL 154 and conductive pillars 146. The first RDL 152 may provide a series of pads, bumps, vias, through-vias, traces, and other forms of connection for redistributing signals from the supporting substrate 102 to the interposer 104. The second RDL 154 in turn may provide a series of pads, bumps, vias, through-vias, traces, and other forms of connection for redistributing signals from the interposer 104 to the compute devices of the base die 106, and the one or more multi-device packages 112. The first RDL 152 and the second RDL 154 with the conductive pillars 146 thus may provide a connection between the supporting substrate 102, the compute devices of the base die 106, and the one or more multi-device packages 112.

In some embodiments, the bonding layer 160 may provide a metallic bonding between the interposer 104 and the supporting substrate 102, a dielectric bonding between the interposer 104 and the supporting substrate 102, or in some embodiments a bonding between the interposer 104 and the supporting substrate 102. In some embodiments, the bonding layer 160 may bond directly with the first RDL 152, while in other embodiments, intermediate layers may between the bonding layer 160 and the first RDL 152. In some embodiments, a dielectric material or adhesive material may be inserted using an underfill technique and form the dielectric bond 162on the surface of the supporting substrate 102.

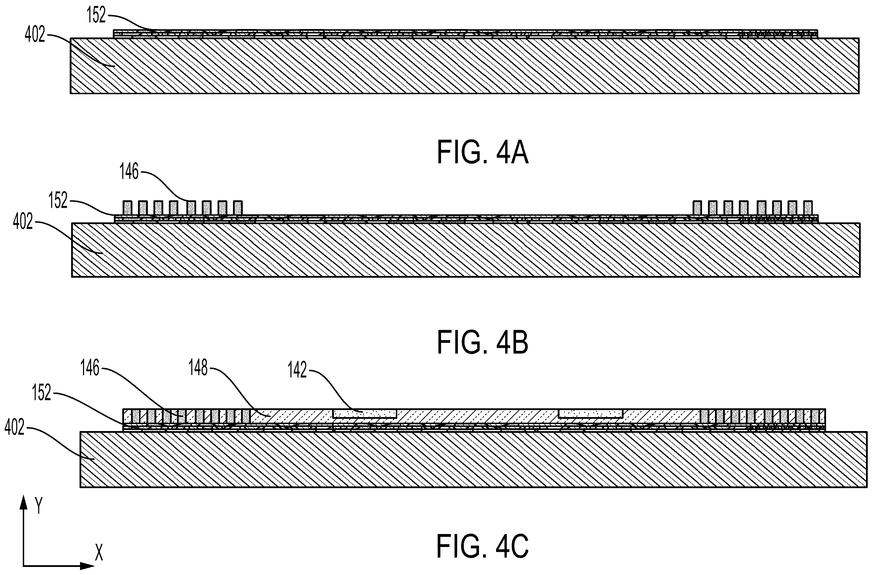

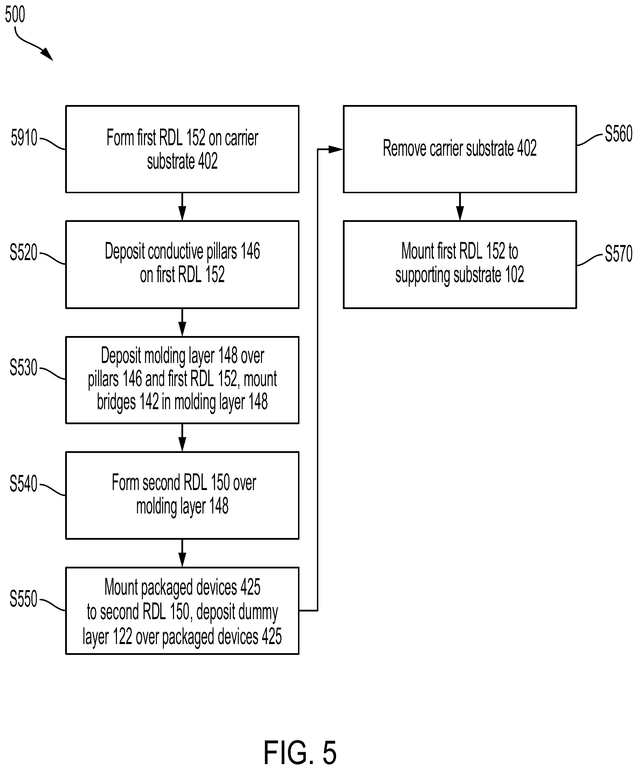

FIGS. 4A-4G depict an illustrative embodiment of a process of forming a device package architecture such as the device package architecture 100, or any other device package architectures shown herein. FIG. 5 depicts an example embodiment of a process 500 for forming a device package assembly corresponding to the illustrative embodiment of FIGS. 4A-4G.

FIG. 4A depicts at S510 in FIG. 5 where the first RDL 152 is formed on a carrier substrate 402. The carrier substrate 402 may be any suitable substrate, such as a glass substrate. In some embodiments, prior to the first RDL 152 being formed on the carrier substrate 402, a release layer (not shown) may be formed on the carrier substrate 402. The release layer may comprise a material such as a polymer, wax, epoxy, or resin which acts as a sacrificial layer and may be cleanly removed from the carrier substrate 402 and the first RDL 152. In some embodiments, the first RDL 152 may be formed using complementary metal-oxide-semiconductor (CMOS) processes, such as depositing, lithography, etching, passivation directly on the carrier substrate 402. In some embodiments, the first RDL 152 may be formed on a separate substrate and transferred to the carrier substrate 402.

FIG. 4B depicts at S520 in FIG. 5 where conductive pillars 146 are formed on the first RDL 152. The conductive pillars 146 may comprise a conductive material, including metals such as copper, as well as other known conductive materials, such as doped carbon. The conductive pillars 146 are bonded to the first RDL 152 and may form an interconnection layer for the second RDL 154 added later. In some embodiments, the conductive pillars 146 may be bonded using metal diffusion bonding between a metallic material forming the conductive pillars 146 and corresponding metal materials within the first RDL 152.

FIG. 4C depicts at S530 in FIG. 5 where the molding layer 148 is deposited over the conductive pillars 146 and the first RDL 152. The molding layer 148 may be a dielectric material, and be deposited to provide electrical separation between the first RDL 152 and the second RDL 154 added in at S540. The molding layer 148 may also provide a dielectric surface for providing a hybrid bonding structure with the second RDL 154 with the base die 106 and the one or more multi-device packages 112. The molding layer 148 may also provide a surface the one or more of the one or more embedded connecting elements 142 may be embedded within, for example, by placing the one or more embedded connecting elements 142 prior to molding. In some embodiments, a die attach film may be placed prior to mounting the one or more embedded connecting elements 142. After embedding one or more of the one or more embedded connecting elements 142, the surface of the one or more of the one or more embedded connecting elements 142, the molding layer 148 and the conductive pillars 146 may be subject to a process to smooth and or planarize the surface, the process including one or more grinding, polishing, and smoothing processes, including chemical mechanical polishing (CMP).

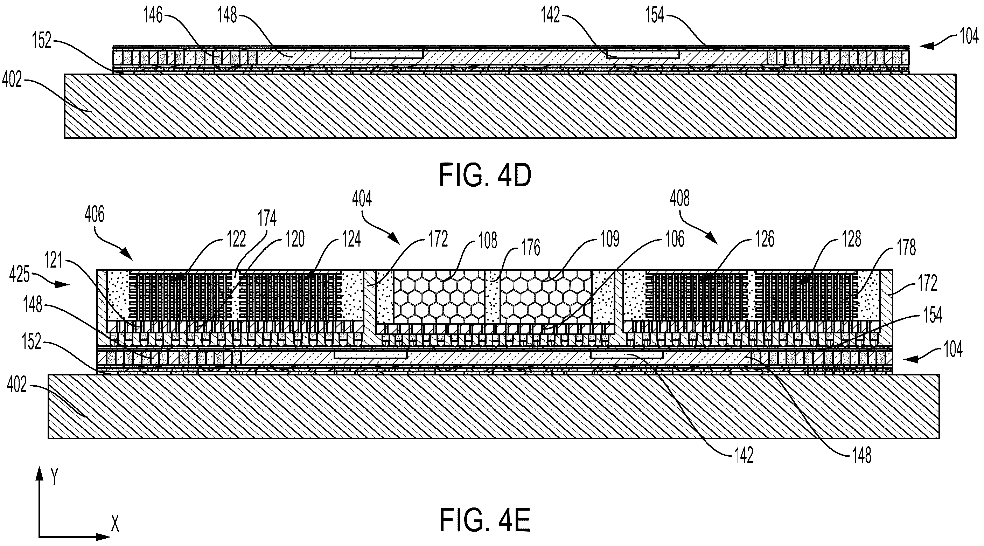

FIG. 4D depicts at S540 in FIG. 5 where the second RDL 154 is formed on the surface of the conductive pillars 146, the molding layer 148, and one or more of the one or more embedded connecting elements 142. The second RDL 154 includes a series of pads, bumps, vias, through-vias, traces, and other forms of connection for redistributing signals from the embedded layers to an appropriate location on the top of second RDL 154. In some embodiments, a portion of the molding layer 148 may be exposed to provide a suitable dielectric surface for forming hybrid bonds. The formation of the second RDL 154 with the first RDL 152, and the components between thus may be referred to as the interposer 104.

FIG. 4E depicts at S550 in FIG. 5 where the packaged devices 425 are mounted upon the interposer 104. The packaged devices 425 includes a first packaged device 404, a second packaged device 406, and a third packaged device 408 which may be individually assembled devices on their own supporting die. For example, a first packaged device 404 may comprise the first compute device 108 and the second compute device 109 on the base die 106, with a central encapsulation layer 176 encapsulating the first compute device 108 and the second compute device 109 on the base die 106. The second packaged device 406 and the third packaged device 408 may each take the form of one or more multi-device packages 112 including the first device 122 and the second device 124 on the multi-device die 120, with a first encapsulation layer 174 encapsulating the first device 122 and the second device 124 on the multi-device die 120. The mounting may be performed by a variety of bonding methods, including metal bonding, dielectric bonding, and hybrid bonding. In addition or in the alternative, additional interconnection techniques may be used, including the use of adhesives such as resins or epoxies. The devices and compute devices, including the first compute device 108, the second compute device 109, and the packaged devices 425 may be formed in one or more front end of line (FEOL) processes, which may be performed separately from the process 500. The devices and compute devices may be mounted using back-end of line (BEOL) processes. In some embodiments, the first encapsulation layer 174, and the central encapsulation layer 176 may be provided prior to mounting the packaged devices 425 upon the interposer 104, while in some embodiments, the first encapsulation layer 174, and the central encapsulation layer 176 may be provided after mounting the packaged devices 425 upon the interposer 104.

After the packaged devices 425 are mounted to the interposer 104, and one or more overmolding layers 172 may be deposited over the first packaged device 404, the second packaged device 406 and the third packaged device 408. The overmolding layers 172 may be deposited to encapsulate the first packaged device 404, the second packaged device 406 and the third packaged device 408 to the interposer 104, as well as to provide mechanical support, thermal insulation, and electrical separation. In some embodiments, the overmolding layers 172 may be one or more layers of a dielectric material, and may be an over molding process. In some embodiments, any excess material deposited on to the devices may be subject to a process to smooth and or planarize the surface of the devices, the process including one or more grinding, polishing, and smoothing processes, including CMP. In some embodiments, a thermal processing step or heat treatment step may be used to secure the overmolding layers 172 in place.

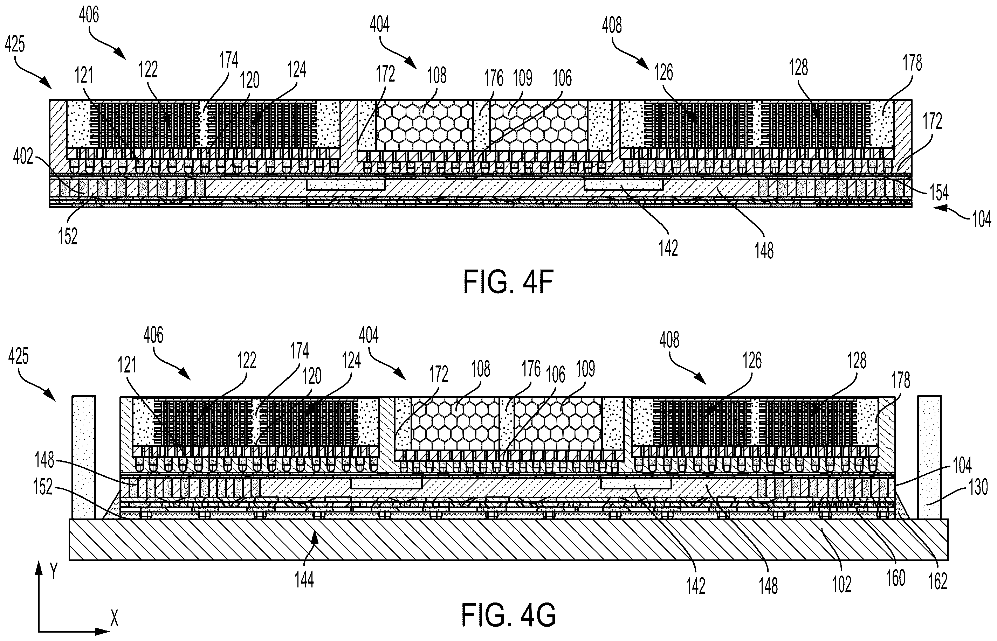

FIG. 4F depicts at S560 in FIG. 5 where the interposer 104 with the packaged devices 425 mounted thereupon is released from the carrier substrate 402 at the first RDL 152. The carrier substrate 402 may be released, for example, by using one or more of layer release, chemical release, thermal release, or photo release techniques to release an adhesive layer coupling the carrier substrate 402 to the first RDL 152. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

Additionally, at S560, interconnections may be prepared for mounting the interposer 104 on to the supporting substrate 102. The interconnections may include pads, bumps, microbumps, pillars, balls, and other forms such as C4 bumps, alone or in combination. In some embodiments, a dielectric layer or adhesive layer, including underfill may also be included.

FIG. 4G depicts at S570 in FIG. 5 where the interposer 104 with the packaged devices 425 mounted thereupon is mounted upon the supporting substrate 102 via the bonding layer 160. The bonding layer 160 may include conductive interconnections to couple the interposer 104 to the supporting substrate 102 including pads, bumps, microbumps, pillars, balls, and other forms such as controlled-collapse chip connection C4 bumps, alone or in combination. In some embodiments, the bonding layer 160 may also include a dielectric material or an adhesive, like underfill material, to provide additional strength and connection between the interposer 104 and the supporting substrate 102. In some embodiments, the bonding layer 160 may provide a metallic bonding between the interposer 104 and the supporting substrate 102, a dielectric bonding between the interposer 104 and the supporting substrate 102, or in some embodiments a hybrid bonding between the interposer 104 and the supporting substrate 102. In some embodiments, the bonding layer 160 may bond directly with the first RDL 152, while in other embodiments, intermediate layers may between the bonding layer 160 and the first RDL 152. In some embodiments, a dielectric material or adhesive material may be inserting using an underfill technique and form the dielectric bond 162on the surface of the supporting substrate 102. In some embodiments, a heat treatment or other thermal process may be provided to strengthen the bond between the supporting substrate 102 and the interposer 104.

Additionally, the stiffener 130 may be formed upon the supporting substrate 102 to surround the interposer 104. The stiffener 130 may be formed directly upon the supporting substrate 102, such as by additive manufacturing of a suitable material to provide additional stiffness to the supporting substrate 102, or may be formed separately and mounted on the supporting substrate 102 using either a bonding process, or an adhesive such as an epoxy or resin. In some embodiments, an additional layer of molding material or encapsulation materials may be deposited between the interposer 104 and the stiffener 130. In some embodiments, a lid may be further mounted on to the device package architecture 100 and be attached to the stiffener 130.

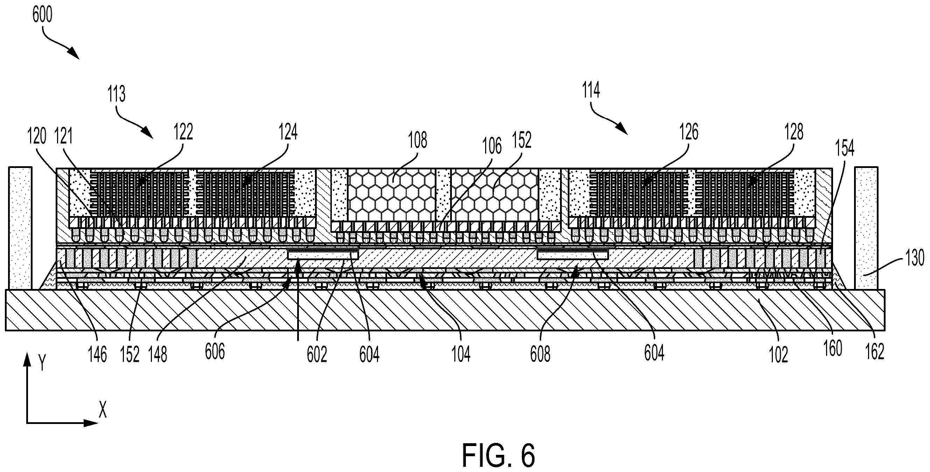

FIG. 6 depicts an exemplary embodiment of a first active device package architecture 600. The first active device package architecture 600 of FIG. 6 differs from the device package architecture 100 as shown in FIG. 3 by including a first active connecting element configuration 602 including one or more circuit elements 604. In some embodiments, the one or more circuit elements 604 may include a plurality of transistors. The transistors may provide different functions and take different forms, including a logic layer. In some embodiments, the one or more circuit elements 604 may act as the interface logic for the multi-device die 120. As used herein, interface logic may refer to a logic circuit providing routing of communication signals and power signals, and may be referred to as a logic layer, or base logic. In some embodiments, the interface logic may be a D2D internet protocol (IP) or D2D IP logic. In some embodiments, the base logic may provide a serial interface logic, a parallel interface logic, or a combination thereof. In some embodiments, a Serializer/Deserializer (SerDes) protocol, a Universal Chiplet Interconnect Express (UCIe) protocol, or any other suitable protocol may be used alone or in any combination thereof.

In some embodiments, each of the one or more embedded connecting elements 142 may take the form of the first active connecting element configuration 602, while in other embodiments, only a portion of the one or more embedded connecting elements 142 may take the form of the first active connecting element configuration 602. In some embodiments, each connecting element may include an interface logic for each multi-device die 120 connected to the connecting element. In the example embodiment of FIG. 6, the first multi-device package 113 is connected to the first compute device 108 with a first active connecting element 606, while the second multi-device package 114 is connected to the first compute device 108 with a second active connecting element 608. In the example embodiment of FIG. 6, the one or more circuit elements 604 of the first active connecting element 606 may provide the interface logic for the first multi-device package 113, while the one or more circuit elements 604 of the second active connecting element 608 may provide the interface logic for the second multi-device package 114. In some embodiments, the interface logic may be the same for each multi-device package 112, while in other embodiments, the interface logic may vary between each multi-device package 112.

The first active device package architecture 600 may be assembled as discussed above with respect to FIG. 4A-4G and the process 500 of FIG. 5, with the first active connecting element configuration 602 replacing the one or more embedded connecting elements 142. In some embodiments, the first active connecting element configuration 602 may be formed in a separate FEOL process to form the one or more circuit elements 604 prior to assembly.

The first active connecting element configuration 602 may allow for a more direct connection between the compute devices of the base die 106 and the multi-device die 120, and may provide a reduction in routing distances, as well as a decrease in latency and an increase in performance for the first active device package architecture 600 as a whole. In addition, utilizing interface logic within the first active connecting element configuration 602 may reduce the communication delays within the multi-device die 120.

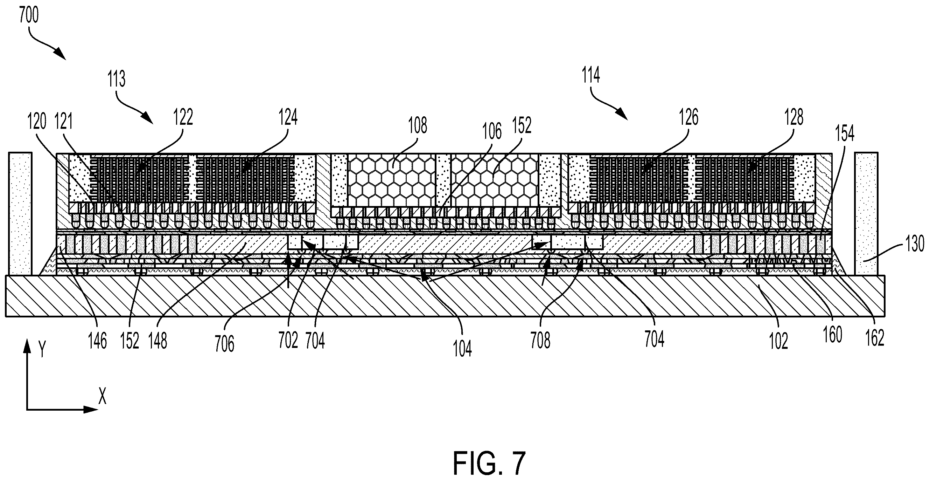

FIG. 7 depicts an exemplary embodiment of a second active device package architecture 700. The second active device package architecture 700 of FIG. 7 differs from the device package architecture 100 as shown in FIG. 3 by including a second active connecting element configuration 702 including one or more vias 704. The one or more vias 704 may provide additional pathways to route power and signals between the first RDL 152 and the second RDL 154, providing additional coupling between the supporting substrate 102 and the devices of the interposer 104, as well as those packages mounted upon the interposer 104. Furthermore, the one or more vias 704 may, in some embodiments, provide a more direct routing between the supporting substrate 102 and the devices of the interposer 104. A more direct routing may decrease the relative distance, and thus decrease the travel time for signals providing a decrease in latency and increase in efficiency. In addition, a shorter routing may reduce energy losses due to resistance across a conductor, and increase the electrical and thermal efficiencies of such a package.

In some embodiments, each of the one or more embedded connecting elements 142 may take the form of the second active connecting element configuration 702, while in other embodiments, only a portion of the one or more embedded connecting elements 142 may take the form of the second active connecting element configuration 702. In some embodiments, each connecting element may include an interface logic for each multi-device die 120 connected to the connecting element. In the example embodiment of FIG. 7, the first multi-device package 113 is connected to the first compute device 108 with a third active connecting element 706, while the second multi-device package 114 is connected to the first compute device 108 with a fourth active connecting element 708.

The one or more vias 704 may comprise a conductive material, including metals such as copper, as well as other known conductive materials, such as doped carbon. The one or more vias 704 are bonded to the first RDL 152 and may form an interconnection layer for the second RDL 154 added later. In some embodiments, the one or more vias 704 may be bonded using metal diffusion bonding between a metallic material forming the one or more vias 704 and corresponding metal materials within the first RDL 152. In some embodiments, the one or more vias 704 may extend such that the molding layer 148 is not present between the second active connecting element configuration 702 and the first RDL 152, such that the second active connecting element configuration 702 is mounted directly on the first RDL 152 using an interconnection. The interconnection may include pads, bumps, microbumps, pillars, balls, and other forms such as C4 bumps, alone or in combination to bond the second active connecting element configuration 702 to the first RDL 152. In some embodiments, a dielectric layer or adhesive layer, including underfill may also be included. In some embodiments, a hybrid bonding process may be used to connect the first RDL 152 to the second active connecting element configuration 702. In some embodiments, a microball array may couple the second active connecting element configuration 702 to the first RDL 152. In some embodiments, multiple active connecting elements may be coupled using one or more microball arrays, for example a first microball array may couple the third active connecting element 706 to the first RDL 152 and a second microball array may couple the fourth active connecting element 708 to the first RDL 152, while in other embodiments any suitable form of connection may be used.

In some embodiments, a connecting element may include elements of either of the first active device package architecture 600 or the second active device package architecture 700 including both of the one or more circuit elements 604 and the one or more vias 704.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first layer including a first compute device, a first device package, and a second device package, wherein the first compute device is arranged between the first device package and the second device package; and
a second layer including a first connecting element and a second connecting element, wherein the first connecting element is configured to electrically connect the first compute device to the first device package and the second connecting element is configured to electrically connect the first compute device to the second device package.

2. The device of claim **1,** wherein the first layer includes a third device package and a fourth device package, wherein the first compute device is arranged between the third device package and the fourth device package,
wherein a third connecting element is configured to electrically connect the first compute device to the third device package and a fourth connecting element is configured to electrically connect the first compute device to the fourth device package, and
wherein the first compute device is arranged between the second device package and the fourth device package.

3. The device of claim 1 or 2, wherein the first connecting element includes a first interface logic, wherein the first interface logic comprises a serial interface logic or a parallel interface logic.

4. The device of claim 1 or 2, wherein the first connecting element includes a first interface logic, wherein the first interface logic connects the first compute device to the first device package.

5. The device of any one of claims 1 to 4, wherein the second layer includes:
a first redistribution layer on a first side of the second layer, the first side of the second layer facing the first layer; and
a second redistribution layer on a second side of the second layer, the second side of the second layer opposite the first side of the second layer.

6. The device of claim 5, wherein the first connecting element is arranged between the first redistribution layer and the second redistribution layer.

7. The device of any one of claims 1 to 6, wherein the first device package includes at least a first device stack and a second device stack on a first device die.

8. The device of claim 7, wherein the first device stack includes at least one of a memory device and a processing device.

9. The device of claim 7 or 8, wherein the first device die is configured to electrically couple the first device stack and the second device stack to the first connecting element.

10. The device of claim 1, wherein:
the first connecting element electrically couples the first compute device to the first device package,
the second connecting element electrically couples the first compute device to the second device package,
the first connecting element includes a first interface logic, and
the second connecting element includes a second interface logic.

11. The device of claim 10,
wherein the first layer further includes a second compute device, a third device package, and a fourth device package,
wherein the second compute device is arranged between the fourth device package and the third device package,
wherein the second layer further includes a third connecting element and a fourth connecting element,
wherein the third connecting element is configured to electrically couple the second compute device to the third device package,
wherein the fourth connecting element is configured to electrically couple the second compute device to the fourth device package, wherein the third connecting element includes a third interface logic, and
wherein the fourth connecting element includes a fourth interface logic.

12. The device of claim 10 or 11, wherein the second layer includes a first redistribution layer on a first side of the second layer, and
wherein the first redistribution layer is arranged between the first connecting element and the first device package.

13. The device of claim 12, wherein the second layer includes a second redistribution layer arranged on a second side of the second layer, the second side opposite the first side, and
wherein the first connecting element is arranged between the first redistribution layer and the second redistribution layer.

14. The device of any one of claims 10 to 13, wherein the first device package includes at least one of a memory device and a processing device.

15. The device of any one of claims 10 to 14, wherein the first layer includes a base die arranged between the first compute device and the first connecting element.
